# FASCICULE DE BREVET EUROPEEN

(11) **EP 3 157 181 B1**
(45) Date de publication et mention de la délivrance du brevet: **27.12.2017**
(21) Numéro de dépôt: 16193628.1
(22) Date de dépôt: 13.10.2016
(51) Int. Cl.: H04B 17/20, H04B 1/7163

(54) **DETECTION DE SIGNAL ULTRA LARGE BANDE**
ULTRA WIDEBAND SIGNALERKENNUNG
ULTRA WIDEBAND SIGNAL DETECTION

(30) Priorité: 14.10.2015 FR 1559754
(43) Date de publication de la demande: 19.04.2017
(73) Titulaire: COMMISSARIAT À L'ÉNERGIE ATOMIQUE ET AUX ÉNERGIES ALTERNATIVES, 75015 Paris (FR)
(72) Inventeur: RIBIERE-THARAUD, Nicolas, 46110 Cavagnac (FR)
(74) Mandataire: Brevalex

(56) Documents cités:
- EP-A1- 1 542 027
- EP-A2- 1 314 996
- US-A- 5 512 823
- US-A1- 2005 179 585
- US-A1- 2009 164 124
- LEI FENG ET AL: "Fast Acquisition for Transmitted Reference Ultra-Wideband Systems with Channelized Receiver", SIGNALS, SYSTEMS AND COMPUTERS, 2005. CONFERENCE RECORD OF THE THIRTY- NINTH ASILOMAR CONFERENCE ON, PACIFIC GROVE, CALIFORNIA OCTOBER 28 - NOVEMBER 1, IEEE, PISCATAWAY, NJ, USA,IEEE, 28 octobre 2005 (2005-10-28), pages 1094-1098, XP010900178, ISBN: 978-1-4244-0131-4

## Description

### DOMAINE TECHNIQUE

La présente invention concerne la sécurité d'installations civiles ou militaires vis-à-vis de contraintes électromagnétiques de type ultra large bande (ULB). Elle concerne plus précisément la détection de signaux radiofréquences, de formes d'ondes très diverses et pouvant avoir une amplitude très élevée. De tels signaux constituent des agressions électromagnétiques susceptibles de perturber ou même détruire l'électronique de ces installations.

### ÉTAT DE LA TECHNIQUE ANTÉRIEURE

L'article intitulé "HPM Detection System for Mobile and Stationary Use", de C. Adami et al., Proc. of the 10th Int. Symposium on Electromagnetic Compatibility (EMC Europe 2011), York, UK, September 26-30, 2011, ainsi que l'article intitulé « HPM detector system with frequency identification » de C. Adami et al., Proc. of the 2014 International Symposium on Electromagnetic Compatibility (EMC Europe 2014), Gothenburg, Sweden, September 1-4, 2014, concernent la détection de signaux micro-ondes de forte puissance (HPM).

Des détecteurs de perturbations électromagnétiques sont décrits par exemple dans WO 2008/100322 ou WO 2011/047377.

Ces dispositifs détectent des signaux radiofréquences et en mesurent des caractéristiques, telles que niveaux crêtes, durées ou taux de répétition des agressions. Les agressions sont discriminées et une alarme peut être générée.

Cependant, ces dispositifs ne permettent pas de détecter ou discriminer des signaux ultra large bande. En effet, leur conception repose sur des composants électroniques, tels que des amplificateurs logarithmiques, qui sont trop lents. Un composant de ce type a un temps de réponse qui est au mieux de l'ordre de 10 nanosecondes, alors que les variations des signaux ultra large bande caractérisant leur pouvoir perturbateur sont de l'ordre de 0,1 nanoseconde, c'est-à-dire cent fois plus rapide.

US 2005/0179585 concerne un système de radar dans lequel de multiples impulsions sont générées. De manière préférentielle, les impulsions comprennent des impulsions ultra-large bande, occupant chacune une sous-bande de la bande totale du système. Ce document a trait à un dispositif de réception de signal ultra-large bande, mais pas à un dispositif de détection de signal ultra-large bande.

US 2009/164124 concerne un récepteur ultra-large bande pour la détection de foudre. Ce récepteur comporte une voie filtrée et une voie non filtrée, cette dernière n'étant utilisée que si la voie filtrée est saturée.

### EXPOSÉ DE L'INVENTION

L'invention vise à résoudre les problèmes de la technique antérieure en fournissant un dispositif de détection de signal ultra large bande, comportant :
- Un circuit de réception de signal,
- Un circuit de division du signal reçu en plusieurs sous-bandes de fréquence,
caractérisé en ce qu'il comporte :
- Un circuit de détermination de l'amplitude et de la durée du signal reçu dans chaque sous-bande de fréquence,
- Un circuit de comparaison de l'amplitude du signal reçu dans chaque sous-bande de fréquence avec un seuil d'amplitude,
- Un circuit de comparaison de la durée du signal reçu dans chaque sous-bande de fréquence avec un seuil temporel, et
- Un circuit de décision qui détermine que le signal reçu est de type ultra large bande si l'amplitude du signal reçu dans chaque sous-bande de fréquence est supérieure au seuil d'amplitude et si la durée du signal reçu dans chaque sous-bande de fréquence est inférieure au seuil temporel.

Grâce à l'invention, la détection de signaux ultra large bande est améliorée car elle permet de s'affranchir des difficultés liées au temps de réponse des composants de détection, tels qu'un amplificateur logarithmique.

Le dispositif selon l'invention peut fonctionner seul ou en réseau, ce qui permet de localiser la source de signaux ultra large bande détectés.

Selon une caractéristique préférée, le dispositif de détection de signal ultra large bande comporte en outre un circuit d'alarme pour signaler que le signal reçu est détecté de type ultra large bande.

Selon une caractéristique préférée, le dispositif de détection de signal ultra large bande comporte en outre un circuit de mémorisation de signal détecté de type ultra large bande. Ainsi une base de données collecte des données liées à la détection des signaux ULB.

Selon une caractéristique préférée, le dispositif de détection de signal ultra large bande comporte en outre un circuit de détermination de l'enveloppe du signal reçu dans chaque sous-bande de fréquence. Cette enveloppe est traitée pour fournir des informations permettant de discriminer un signal ULB.

Selon une caractéristique préférée, le dispositif de détection de signal ultra large bande est adapté à mettre en oeuvre une phase d'apprentissage au cours de laquelle des signaux détectés de type ultra large bande sont mémorisés en tant que signaux de référence. Ainsi le dispositif de détection selon l'invention peut fonctionner dans un environnement électromagnétique perturbé sans générer de fausses alarmes.

Selon une caractéristique préférée, le circuit de décision est adapté à comparer un signal détecté de type ultra large bande aux signaux de référence. Lorsqu'il y a analogie entre le signal détecté et un signal de référence, le signal détecté ne donne pas lieu à une génération d'alarme.

L'invention concerne aussi un procédé de détection de signal ultra large bande, comportant des étapes de :
- réception de signal,
- division du signal reçu en plusieurs sous-bandes de fréquence, caractérisé en ce qu'il comporte des étapes de :
- détermination de l'amplitude et de la durée du signal reçu dans chaque sous-bande de fréquence,
- comparaison de l'amplitude du signal reçu dans chaque sous-bande de fréquence avec un seuil d'amplitude,
- comparaison de la durée du signal reçu dans chaque sous-bande de fréquence avec un seuil temporel, et
- décision pour déterminer que le signal reçu est de type ultra large bande si l'amplitude du signal reçu dans chaque sous-bande de fréquence est supérieure au seuil d'amplitude et si la durée du signal reçu dans chaque sous-bande de fréquence est inférieure au seuil temporel.

Le procédé présente des avantages analogues à ceux précédemment présentés.

Dans un mode particulier de réalisation, les étapes du procédé selon l'invention sont mises en oeuvre par des instructions de programme d'ordinateur.

En conséquence, l'invention vise aussi un programme d'ordinateur sur un support d'informations, ce programme étant susceptible d'être mis en oeuvre dans un ordinateur, ce programme comportant des instructions adaptées à la mise en oeuvre des étapes d'un procédé tel que décrit ci-dessus.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions de programme d'ordinateur adaptées à la mise en oeuvre des étapes d'un procédé tel que décrit ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé selon l'invention.

### BRÈVE DESCRIPTION DES DESSINS

D'autres caractéristiques et avantages apparaîtront à la lecture de la description suivante d'un mode de réalisation préféré, donné à titre d'exemple non limitatif, décrit en référence aux figures dans lesquelles :
Les figures 1a, 1b et 1c représentent des exemples de signaux ultra large bande à détecter,
La figure 2 représente un dispositif de détection de signal ultra large bande, selon un mode de réalisation de l'invention,
La figure 3 représente un procédé de détection de signal ultra large bande, selon un mode de réalisation de l'invention,
La figure 4 représente une phase d'apprentissage du procédé de détection de signal ultra large bande, selon un mode de réalisation de l'invention.

### EXPOSÉ DÉTAILLÉ DE MODES DE RÉALISATION PARTICULIERS

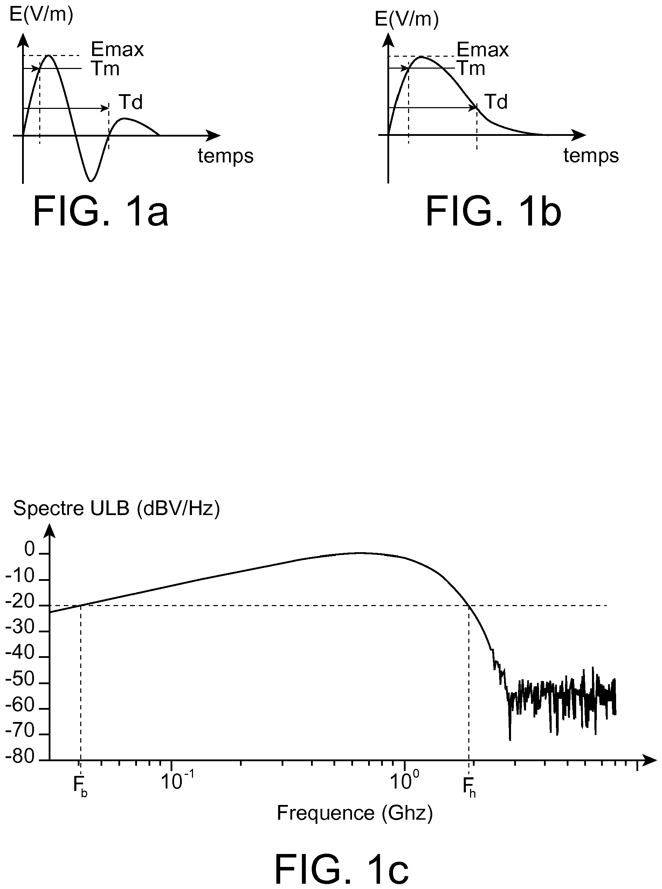

Les **figures 1a et 1b** représentent des exemples de signaux à détecter. Il s'agit de signaux radiofréquence, dont on a représenté l'amplitude en champ électrique en fonction du temps. Les signaux à détecter sont des signaux ultra large bande qui présentent une forme temporelle soit bi polaire (figure 1a), c'est-à-dire ayant une alternance positive et une alternance négative, soit mono polaire (figure 1b), c'est-à-dire ayant seulement une alternance positive.

Dans les deux cas, le temps de montée Tm est de l'ordre de 0,1 nanoseconde et la durée moyenne Td est de l'ordre 10 nanosecondes. L'amplitude Emax du signal ultra large bande peut varier de quelques V/m à plusieurs dizaines de KV/m, en fonction de la puissance de la source du signal et de la distance entre la source du signal et le détecteur.

La **figure 1c** représente le spectre d'un signal ultra large bande.

La couverture en fréquence du signal ultra large bande se traduit par un rapport de bande RB = Fh/Fb supérieur à 10, où Fh est la fréquence haute du signal et Fb est la fréquence basse du signal. Le rapport de bande RB est d'autant plus élevé que le temps de montée Tm est faible.

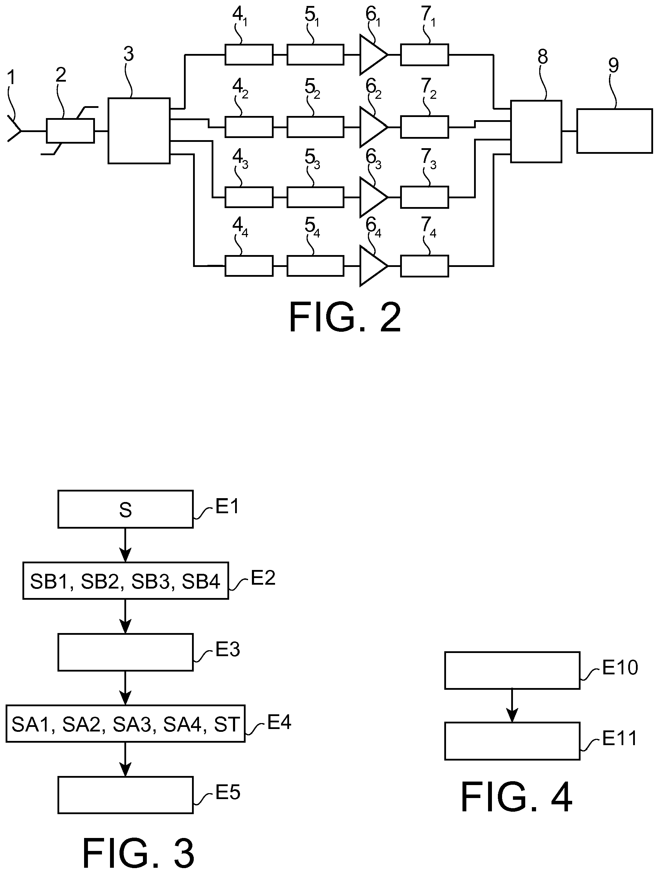

Selon un mode de réalisation préféré, représenté à la **figure 2**, le dispositif de détection de signal ultra large bande selon l'invention comporte les éléments suivants.

Le dispositif de détection de signal ultra large bande comporte une ou plusieurs antennes 1 de réception de signal ultra large bande. Il s'agit par exemple d'une antenne monopole. Une seule antenne est représentée à la figure 2, mais le dispositif peut comporter plusieurs antennes pour le rendre indépendant de la direction du signal à détecter et de l'orientation du champ électrique.

La sortie de l'antenne 1 est reliée à l'entrée d'un limiteur 2 qui protège les composants électroniques en aval. Le limiteur écrête le signal reçu par l'antenne 1 au-dessus d'un seuil prédéterminé. Ainsi le limiteur 2 produit en sortie un signal limité dont l'amplitude est compatible avec la protection des composants électroniques en aval.

La sortie du limiteur 2 est reliée à l'entrée d'un diviseur de puissance 3 qui distribue le signal qu'il reçoit sur plusieurs voies parallèles de manière identique. Dans l'exemple représenté, le diviseur de puissance 3 comporte quatre sorties à titre d'exemple.

Chaque sortie est reliée à une branche respective. Les branches sont similaires.

Une branche comporte en entrée un atténuateur respectif 4₁, 4₂, 4₃ et 4₄ qui assure une amplitude de signal compatible avec les composants électroniques en aval.

La sortie de chaque atténuateur 4₁, 4₂, 4₃ et 4₄ est reliée à l'entrée d'un filtre passe-bande respectif 5₁, 5₂, 5₃ et 5₄.

Chaque filtre passe-bande 5₁, 5₂, 5₃ et 5₄ divise le contenu spectral du signal qu'il reçoit en une sous-bande respective. Les sous-bandes sont adjacentes et leur réunion recouvre la couverture fréquentielle du signal ultra large bande à détecter. Par exemple, le filtre 5₁ correspond à la sous-bande de 0 à 0,1 GHz, le filtre 5₂ correspond à la sous-bande de 0,1 à 0,5 GHz, le filtre 5₃ correspond à la sous-bande de 0,5 à 1 GHz et le filtre 5₄ correspond à la sous-bande de 1 à 3 GHz. Un léger recouvrement entre sous-bandes est possible.

La sortie de chaque filtre passe-bande 5₁, 5₂, 5₃ et 5₄ est reliée à l'entrée d'un amplificateur logarithmique respectif 6₁, 6₂, 6₃, et 6₄ qui fournit l'enveloppe du signal dans une sous-bande respective définie par le filtre passe-bande 5₁, 5₂, 5₃ et 5₄.

Il est à noter que le temps de réponse des amplificateurs logarithmiques dans les bandes de fréquences les plus basses est compatible avec la détection de signaux de type ULB.

La sortie de chaque amplificateur logarithmique 6₁, 6₂, 6₃, et 6₄ est reliée à l'entrée d'un convertisseur analogique/numérique respectif 7₁, 7₂, 7₃, et 7₄ qui fournit un signal numérique représentatif de l'enveloppe du signal dans une sous-bande respective.

La sortie de chaque convertisseur analogique/numérique 7₁, 7₂, 7₃, et 7₄ est reliée à l'une respective des entrées d'un module de calcul 8.

Le module de calcul 8 est un microcontrôleur programmable qui dispose de capacités de calcul et de mémoire. Il s'agit par exemple d'un composant de type FPGA.

Le module de calcul 8 reçoit les signaux issus des convertisseurs analogiques/numériques 7₁, 7₂, 7₃, et 7₄ et détermine si le signal reçu est un signal de type ULB ou non. Pour cela, l'amplitude et la durée du signal reçu dans chacune des sous-bandes de fréquences sont déterminées. Un signal est détecté comme étant de type ultra large bande si les amplitudes dans chacune des sous-bandes de fréquences sont simultanément élevées et si la durée totale du signal détecté est de l'ordre de 10 à 20 nanosecondes. Cette approche permet de se prémunir des difficultés liées au temps de montée du composant de détection. Le fonctionnement du module de calcul 8 est détaillé dans la suite.

La sortie du module de calcul 8 est reliée à un module d'alarme 9. Le module de calcul 8 transmet un signal d'information au module d'alarme 9 si le signal reçu par le dispositif de détection est de type ULB. Le module d'alarme 9 émet alors une alarme qui peut être sonore et/ou visuelle. L'alarme peut également être un signal électrique contenant les informations d'alerte qui est émis vers un système de traitement distant.

La **figure 3** représente le fonctionnement du dispositif de détection de signal ultra large bande, sous la forme d'un organigramme comportant des étapes E1 à E5.

L'étape E1 est la réception d'un signal S par l'antenne 1.

L'étape suivante E2 est la division du signal S reçu en plusieurs sous-bandes de fréquence. Les sous-bandes sont adjacentes et leur réunion recouvre la couverture fréquentielle du signal ultra large bande à détecter. Par exemple, le signal est divisé en quatre sous-bandes de fréquence SB1, SB2, SB3 et SB4.

A l'étape suivante E3, l'enveloppe du signal divisé est déterminée pour chaque sous-bande.

L'étape suivante E4 est la comparaison de l'amplitude du signal dans chaque sous-bande avec un seuil d'amplitude prédéterminé respectif SA1, SA2, SA3 et SA4, et la comparaison de la durée totale du signal détecté avec un seuil temporel prédéterminé ST. Le seuil temporel est le même pour toutes les sous-bandes et est par exemple égal à 10 nanosecondes.

Si l'amplitude du signal détecté dans chaque sous-bande est supérieure au seuil d'amplitude SA et si la durée totale du signal détecté est inférieure au seuil temporel ST, alors le signal détecté S est identifié comme étant du type ultra large bande.

De préférence, un signal ULB détecté est en outre comparé à des signaux ULB de référence mémorisés dans le module de calcul 8. Ces signaux ULB de référence sont déterminés au cours d'une phase d'apprentissage qui sera décrite dans la suite. Ils constituent des signaux de l'environnement électromagnétique normal du dispositif. Si le signal détecté est similaire à un signal ULB de référence, il n'est pas considéré comme devant générer une alarme.

La comparaison est réalisée sur un certain nombre de critères, par exemple l'amplitude mesurée dans chaque sous bande, la durée, le taux de répétition, l'heure et la date de l'évènement. Tout ou partie de ces critères sont de préférence paramétrables par un utilisateur.

Des marges d'erreur, également paramétrables par l'utilisateur, sont prises en compte pour chacune des comparaisons effectuées.

Si les signaux détectés sont des évènements répétitifs, les amplitudes et durées minimum, maximum, moyennes ainsi que toute autre statistique qui peut en être déduite (écart type,...) sont aussi des critères qui peuvent être utilisés.

Des critères de comparaison et/ou de discrimination peuvent être formés à partir de la forme de l'enveloppe : pente du premier front de montée, temps de décroissance, forme de la décroissance. Ces données sont déterminées par le module de calcul à partir de l'enregistrement de l'enveloppe. Plusieurs de ces critères peuvent être nécessaires. Les critères sont valables pour toutes les sous bandes.

Dans tous les cas, les caractéristiques du signal ULB détecté sont enregistrées, ce qui permet d'établir un journal de l'environnement électromagnétique du dispositif de détection.

L'étape suivante E5 est l'émission d'une alarme lorsque le signal détecté S est identifié comme étant du type ultra large bande et le cas échéant différent des signaux de référence, à l'étape précédente. L'alarme est émise par le module d'alarme 9. Elle peut être sonore et/ou visuelle. L'alarme peut également être un signal électrique contenant les informations d'alerte qui est émis vers un système de traitement distant.

La **figure 4** représente une phase d'apprentissage du dispositif de détection de signal ultra large bande, sous la forme d'un organigramme comportant des étapes E10 à E11.

L'apprentissage est mis en oeuvre à la mise en service du dispositif. Il peut également être mis en oeuvre ponctuellement au cours de l'utilisation du dispositif de détection.

L'étape E10 est l'enregistrement des signaux détectés dans chaque sous-bande de fréquence pendant une durée prédéterminée pouvant aller de quelques secondes à plusieurs heures. Pour cela, les étapes E1 à E4 précédemment décrites sont mises en oeuvre. Si des signaux ULB sont détectés durant la phase d'apprentissage, ils sont considérés comme faisant partie de l'environnement électromagnétique normal du dispositif. Ils constituent des signaux de référence.

L'étape suivante E11 est la mémorisation des caractéristiques des signaux de référence dans le module de calcul 8.

Les caractéristiques qui sont mémorisées sont celles qui servent dans l'étape ultérieure de comparaison E4.

De préférence, plusieurs détecteurs de signaux ULB équipent une installation à surveiller. Les détecteurs sont alors suffisamment espacés les uns des autres, par exemple d'une dizaine de mètres, et ils sont parfaitement synchronisés grâce à leur module de calcul respectif. En variante, la synchronisation peut être faite aussi à l'aide d'une puce GPS permettant d'obtenir une bonne référence de temps. La puce GPS est un composant complémentaire connecté au module de calcul 8 ou intégré à celui-ci.

## Revendications

1. Dispositif de détection de signal ultra large bande, comportant :
- Un circuit de réception de signal,
- Un circuit (3) de division du signal reçu en plusieurs sous-bandes de fréquence,
- Un circuit (8) de détermination de l'amplitude et de la durée du signal reçu dans chaque sous-bande de fréquence,
- Un circuit (8) de comparaison de l'amplitude du signal reçu dans chaque sous-bande de fréquence avec un seuil d'amplitude,
- Un circuit (8) de comparaison de la durée du signal reçu dans chaque sous-bande de fréquence avec un seuil temporel, et
- Un circuit (8) de décision qui détermine que le signai reçu est de type ultra large bande si l'amplitude du signal reçu dans chaque sous-bande de fréquence est supérieure au seuil d'amplitude et si la durée du signal reçu dans chaque sous-bande de fréquence est inférieure au seuil temporel.

2. Dispositif de détection de signal ultra large bande selon la revendication 1, **caractérisé en ce qu'**il comporte en outre un circuit (9) d'alarme pour signaler que le signal reçu est détecté de type ultra large bande.

3. Dispositif de détection de signal ultra large bande selon la revendication 1 ou 2, **caractérisé en ce qu'**il comporte en outre un circuit de mémorisation de signal détecté de type ultra large bande.

4. Dispositif de détection de signal ultra large bande selon la revendication 1, **caractérisé en ce qu'**il comporte en outre un circuit de détermination de l'enveloppe du signal reçu dans chaque sous-bande de fréquence.

5. Dispositif de détection de signal ultra large bande selon l'une quelconque des revendications 1 à 4, **caractérisé en ce qu'**il est adapté à mettre en oeuvre une phase d'apprentissage au cours de laquelle des signaux détectés de type ultra large bande sont mémorisés en tant que signaux de référence.

6. Dispositif de détection de signal ultra large bande selon la revendication 5, **caractérisé en ce que** le circuit de décision est adapté à comparer un signal détecté de type ultra large bande aux signaux de référence.

7. Procédé de détection de signal ultra large bande, comportant des étapes de :
- réception (E1) de signal,
- division (E2) du signal reçu en plusieurs sous-bandes de fréquence,
- détermination (E4) de l'amplitude et de la durée du signal reçu dans chaque sous-bande de fréquence,
- comparaison (E4) de l'amplitude du signal reçu dans chaque sous-bande de fréquence avec un seuil d'amplitude,
- comparaison (E4) de la durée du signal reçu dans chaque sous-bande de fréquence avec un seuil temporel, et
- décision (E4) pour déterminer que le signal reçu est de type ultra large bande si l'amplitude du signal reçu dans chaque sous-bande de fréquence est supérieure au seuil d'amplitude et si la durée du signal reçu dans chaque sous-bande de fréquence est inférieure au seuil temporel.

8. Programme d'ordinateur comportant des instructions pour l'exécution des étapes du procédé selon la revendication 7 lorsque ledit programme est exécuté par un ordinateur.

9. Support d'enregistrement lisible par un ordinateur sur lequel est enregistré un programme d'ordinateur comprenant des instructions pour l'exécution des étapes du procédé selon la revendication 7.

## Patentansprüche

1. Vorrichtung zur Ultra Wideband Signalerkennung, enthaltend:
- eine Signalempfangsschaltung,
- eine Teilungsschaltung (3) zum Aufteilen des empfangenen Signals in mehrere Frequenzunterbänder,
- eine Ermittlungsschaltung (8) zum Ermitteln der Amplitude und der Zeitdauer des empfangenen Signals in jedem Frequenzunterband,
- eine Vergleichsschaltung (8) zum Vergleichen der Amplitude des empfangenen Signals in jedem Frequenzunterband mit einem Amplitudenschwellwert,
- eine Vergleichsschaltung (8) zum Vergleichen der Zeitdauer des empfangenen Signals in jedem Frequenzunterband mit einem Zeitschwellwert,
- eine Entscheidungsschaltung (8), die ermittelt, dass das empfangene Signal vom Typ Ultra Wideband ist, wenn die Amplitude des empfangenen Signals in jedem Frequenzunterband höher als der Amplitudenschwellwert ist und wenn die Zeitdauer des empfangenden Signals in jedem Frequenzunterband geringer als der Zeitschwellwert ist.

2. Vorrichtung zur Ultra Wideband Signalerkennung nach Anspruch 1, **dadurch gekennzeichnet, dass** sie ferner eine Alarmschaltung (9) enthält, um zu melden, dass das empfangene Signal als vom Typ Ultra Wideband erfasst ist.

3. Vorrichtung zur Ultra Wideband Signalerkennung nach Anspruch 1 oder 2, **dadurch gekennzeichnet, dass** sie ferner eine Speicherschaltung zum Abspeichern des erfassten Signals vom Typ Ultra Wideband enthält.

4. Vorrichtung zur Ultra Wideband Signalerkennung nach Anspruch 1, **dadurch gekennzeichnet, dass** sie ferner eine Ermittlungsschaltung zum Ermitteln der Einhüllenden des empfangenen Signals in jedem Frequenzunterband enthält.

5. Vorrichtung zur Ultra Wideband Signalerkennung nach einem der Ansprüche 1 bis 4, **dadurch gekennzeichnet, dass** sie dazu ausgelegt ist, eine Einlernphase durchzuführen, bei der erfasste Signale vom Typ Ultra Wideband als Referenzsignale abgespeichert werden.

6. Vorrichtung zur Ultra Wideband Signalerkennung nach Anspruch 5, **dadurch gekennzeichnet, dass** die Entscheidungsschaltung dazu ausgelegt ist, ein erfasstes Signal vom Typ Ultra Wideband mit den Referenzsignalen zu vergleichen.

7. Verfahren zur Ultra Wideband Signalerkennung, umfassend nachfolgende Schritte:
- Empfangen (E1) eines Signals,
- Aufteilen (E2) des empfangenen Signals in mehrere Frequenzunterbänder,
- Ermitteln (E4) der Amplitude und der Zeitdauer des empfangenen Signals in jedem Frequenzunterband,
- Vergleichen (E4) der Amplitude des empfangenen Signals in jedem Frequenzunterband mit einem Amplitudenschwellwert,
- Vergleichen (E4) der Zeitdauer des empfangenen Signals in jedem Frequenzunterband mit einem Zeitschwellwert, und
- Entscheiden (E4) zum Ermitteln, dass das empfangene Signal vom Typ Ultra Wideband ist, wenn die Amplitude des empfangenen Signals in jedem Frequenzunterband höher als der Amplitudenschwellwert ist und wenn die Zeitdauer des empfangenen Signals in jedem Frequenzunterbrand geringer als der Zeitschwellwert ist.

8. Computerprogramm mit Anweisungen zum Durchführen der Schritte des Verfahrens nach Anspruch 7 bei Ausführung des Programms durch einen Computer.

9. Computerlesbarer Aufzeichnungsträger, auf dem ein Computerprogramm aufgezeichnet ist, das Anweisungen zum Durchführen der Schritte des Verfahrens an Anspruch 7 enthält.

## Claims

1. Device for the detection of an ultra wide band signal, comprising:
- A signal reception circuit,
- A signal divider circuit (3) to divide the received signal into several frequency sub-bands,
- A circuit (8) to determine the amplitude and duration of the signal received in each frequency sub-band,
- A circuit (8) to compare the amplitude of the signal received in each frequency sub-band with an amplitude threshold,
- A circuit (8) to compare the duration of the signal received in each frequency sub-band with a time threshold, and
- A decision circuit (8) that determines that the received signal is of the ultra wide band type if the amplitude of the signal received in each frequency sub-band is higher than the amplitude threshold and if the duration of the signal received in each frequency sub-band is less than the time threshold.

2. Device for the detection of an ultra wide band signal according to claim 1, **characterised in that** it also comprises an alarm circuit (9) to signal that the received signal is of the ultra wide band type.

3. Device for the detection of an ultra wide band signal according to claim 1 or 2, **characterised in that** it also comprises a circuit to store the detected ultra wide band type signal.

4. Device for the detection of an ultra wide band signal according to claim 1, **characterised in that** it also comprises a circuit to determine the envelope of the signal received in each frequency sub-band.

5. Device for the detection of an ultra wide band signal according to anyone of claims 1 to 4, **characterised in that** it is adapted to implement a learning phase during which detected ultra wide band type signals are stored as reference signals.

6. Device for the detection of an ultra wide band signal according to claim 5, **characterised in that** the decision circuit is adapted to compare an detected ultra wide band type signal with the reference signals.

7. Method of detecting an ultra wide band signal, comprising the following steps:
- reception (E1) of the signal,
- division (E2) of the received signal into several frequency sub-bands,
- determination (E4) of the amplitude and duration of the signal received in each frequency sub-band,
- comparison (E4) of the amplitude of the signal received in each frequency sub-band with an amplitude threshold,
- comparison (E4) of the duration of the signal received in each frequency sub-band with a time threshold, and
- decision (E4) to determine that the received signal is of the ultra wide band type if the amplitude of the signal received in each frequency sub-band is higher than the amplitude threshold and if the duration of the signal received in each frequency sub-band is less than the time threshold.

8. Computer program containing instructions for execution of the steps in the method according to claim 7 when said program is executed by a computer.

9. Storage medium that can be read by a computer, in which a computer program is stored containing instructions for execution of the steps in the method according to claim 7.
